**Europäisches Patentamt**

**European Patent Office**

**Office européen des brevets**

(19)

(11) Numéro de publication : **0 323 367 B1**

(12) ## FASCICULE DE BREVET EUROPEEN

(45) Date de publication du fascicule du brevet :
**11.03.92 Bulletin 92/11**

(51) Int. Cl.$^5$ : **H03K 17/22, H03K 3/353**

(21) Numéro de dépôt : **88403379.6**

(22) Date de dépôt : **30.12.88**

(54) **Circuit de remise sous tension pour circuit intégré en technologie MOS.**

(30) Priorité : **30.12.87 FR 8718369**

(43) Date de publication de la demande :
**05.07.89 Bulletin 89/27**

(45) Mention de la délivrance du brevet :
**11.03.92 Bulletin 92/11**

(84) Etats contractants désignés :
**DE ES GB IT**

(56) Documents cités :
**EP-A- 0 150 480**
**FR-A- 2 549 317**
**GB-A- 2 102 646**

(73) Titulaire : **SGS-THOMSON MICROELECTRONICS S.A.**
**7, Avenue Galliéni**
**F-94250 Gentilly (FR)**

(72) Inventeur : **Dubujet, Bruno**
**Cabinet BALLOT-SCHMIT 84 avenue Kléber**
**F-75116 Paris (FR)**

(74) Mandataire : **Ballot, Paul Denis Jacques et al**
**Cabinet Ballot-Schmit 7, rue le Sueur**
**F-75116 Paris (FR)**

## Description

La présente invention concerne un circuit de remise sous tension d'un circuit intégré en technologie MOS (métal, oxyde, semi-conducteur), plus particulièrement d'un circuit en technologie C-MOS (MOS complémentaire).

Dans certains types de circuits intégrés, tout particulièrement ceux qui contiennent des bascules, il est important que certains points du circuit prennent un état logique bien défini lorsqu'on met le circuit sous tension après une interruption de l'alimentation. En effet, il faut éviter que des états logiques incertains ou erronés n'apparaissent durant la montée de la tension d'alimentation et ne se répercutent ensuite durant le fonctionnement du circuit.

Or, l'état des noeuds d'un circuit logique ne peut véritablement prendre une valeur certaine que si la tension d'alimentation du circuit dépasse une valeur minimale. A titre d'exemple, pour un circuit logique réalisé en technologie C-MOS, cette valeur minimale est de 3 Volts. Pour une tension inférieure, les noeuds ont des potentiels variables qui dépendent plus des couplages capacitifs du circuit que de données purement logiques. D'autre part, ces potentiels peuvent différer d'un circuit à l'autre dans une fabrication en série.

Pour remédier à cet inconvénient, on utilise donc un circuit de remise sous tension qui délivre une impulsion de positionnement lorsque la tension d'alimentation a atteint une valeur suffisante pour permettre de positionner le circuit logique grâce à un cycle de fonctionnement à vide. Pour fonctionner correctement, les circuits de remise sous tension doivent répondre à un certain nombre de critères. Ils doivent être rapides pour fonctionner avec des temps de montée de l'alimentation compris entre une microseconde et une seconde. Ils doivent déclencher pour une tension supérieure à 3 Volts mais inférieure à 4,5 Volts. D'autre part, l'impulsion de déclenchement doit parvenir au circuit avant que l'alimentation ne soit stabilisée à sa valeur finale. De plus, ils doivent pouvoir fonctionner dans un environnement en température compris entre -55°C et +125°C.

La présente invention a donc pour but de proposer un nouveau circuit de remise sous tension qui répond aux critères mentionnés ci-dessus et qui soit plus fiable que dans l'art antérieur, tel qu'illustré par exemple le brevet GB-A- 2 102 646.

Ainsi, la présente invention a pour objet un circuit de remise sous tension pour assurer le démarrage d'un circuit intégré en technologie MOS, comprenant :
– une borne recevant la tension d'alimentation, une borne de masse et une borne de sortie délivrant une impulsion de démarrage,
– une capacité connectée entre la borne de masse et un premier noeud de circuit, capacité dont la charge est commandée par un premier transistor de type P,
– une porte inverseuse dont l'entrée est connectée au premier noeud de circuit,
– une source de courant commandant le premier transistor de type P,
– un circuit présentant une fonction de transfert de type inverseur, ledit circuit étant connecté à la source de courant de manière à commander le fonctionnement de celle-ci,
le circuit de remise sous tension étant caractérisé en ce que :
– le premier transistor de type p est connecté entre la borne A et le premier noeud,
– la porte inverseuse a un seuil modifiable,
– un inverseur est connecté entre la sortie de la porte inverseuse et la borne de sortie,
– un circuit diviseur, destiné à la commande de seuil de la porte inverseuse, est connecté en série avec la source de courant,
– et l'entrée du circuit à fonction de transfert du type inverseur est connectée à la sortie de la porte inverseuse.

Selon un mode de réalisation préférentiel, la porte inverseuse à tension de seuil modifiable est constituée par un inverseur relié à la borne de masse par l'intermédiaire d'un deuxième transistor dont la grille est connectée en sortie du circuit diviseur.

D'autre part, selon une autre caractéristique de la présente invention, il comporte de plus un troisième transistor monté en parallèle sur le deuxième transistor, la grille du troisième transistor étant reliée à la borne de sortie. Ce troisième transistor a pour effet de verrouiller le système lorsque la sortie S a basculé dans l'état autorisant l'alimentation du circuit intégré.

Selon un mode de réalisation de la présente invention, le circuit diviseur est constitué par deux transistors MOS montés en diode. De préférence, les deux transistors sont des transistors de type n présentant des tensions de seuil différentes dues à leur différence de géométrie. D'autre part, la source de courant est constituée par un transistor de type p.

Conformément à la présente invention, divers modes de réalisation peuvent être utilisés pour réaliser le circuit présentant une fonction de transfert $V_S$ = f ($V_E$) de type inverseur.

Selon un premier mode de réalisation, ce circuit peut être constitué par un simple inverseur formé, de préférence, par des transistors MOS présentant des tensions de seuil différentes et contrôlées en fonction du type de fonction de transfert à obtenir.

Selon un autre mode de réalisation, ce circuit est constitué par un inverseur comportant entre un cinquième transistor de type p et un sixième transistor de type n, un transistor monté en diode, la sortie de l'inverseur étant prélevée au noeud formé entre le transistor de type p et le transistor monté en diode. Dans ce cas, le circuit présente une fonction anti-retour telle que la tension de sortie $V_S$ ne puisse pas revenir à zéro après un premier fonctionnement.

Selon un mode de réalisation préférentiel, ledit circuit présentant une fonction de transfert $V_S = f(V_E)$ de type inverseur est constitué par le montage en série entre la borne d'alimentation et la borne de masse d'un cinquième transistor de type p, d'un transistor monté en diode et d'un sixième transistor de type n, la borne d'entrée du circuit étant connectée, par l'intermédiaire d'un septième transistor de type n dont la grille est reliée à la borne recevant l'alimentation, à la grille du cinquième transistor de type p et directement à la grille du sixième transistor du type n et la borne de sortie du circuit étant réalisée au niveau du noeud de circuit formé entre le cinquième transistor du type p et le transistor monté en diode.

Dans ce cas, la courbe de transfert présente différentes pentes. Elle comporte aussi, comme précédemment, une fonction anti-retour.

D'autre part, pour positionner correctement le circuit lors du démarrage, celui-ci comporte en outre un certain nombre de capacités placées correctement en différents noeuds du circuit. De préférence, ces capacités sont constituées par des transistors MOS de type p dont les deux électrodes principales sont court-circuitées et dont la grille est reliée soit à la borne recevant l'alimentation soit à la borne de masse.

D'autres caractéristiques et avantages de la présente invention apparaîtront à la lecture de la description de différents modes de réalisation faite ci-après avec référence aux dessins ci-annexés dans lesquels :
– la figure 1 est un schéma d'un mode de réalisation d'un circuit de remise sous tension conforme à la présente invention,
– les figures 2, 3 et 4 sont des schémas de différents modes de réalisation du circuit présentant une fonction de transfert $V_S = f(V_E)$ de type inverseur utilisé dans le circuit de la présente invention,
– la figure 5 représente les fonctions de transfert $V_S = f(V_E)$ pour les différents circuits des figures 2, 3 et 4, et
– la figure 6 représente des diagrammes de variations de tension en fonction du temps en divers points du circuit.

Pour simplifier la description, dans les différentes figures, les mêmes éléments portent les mêmes références.

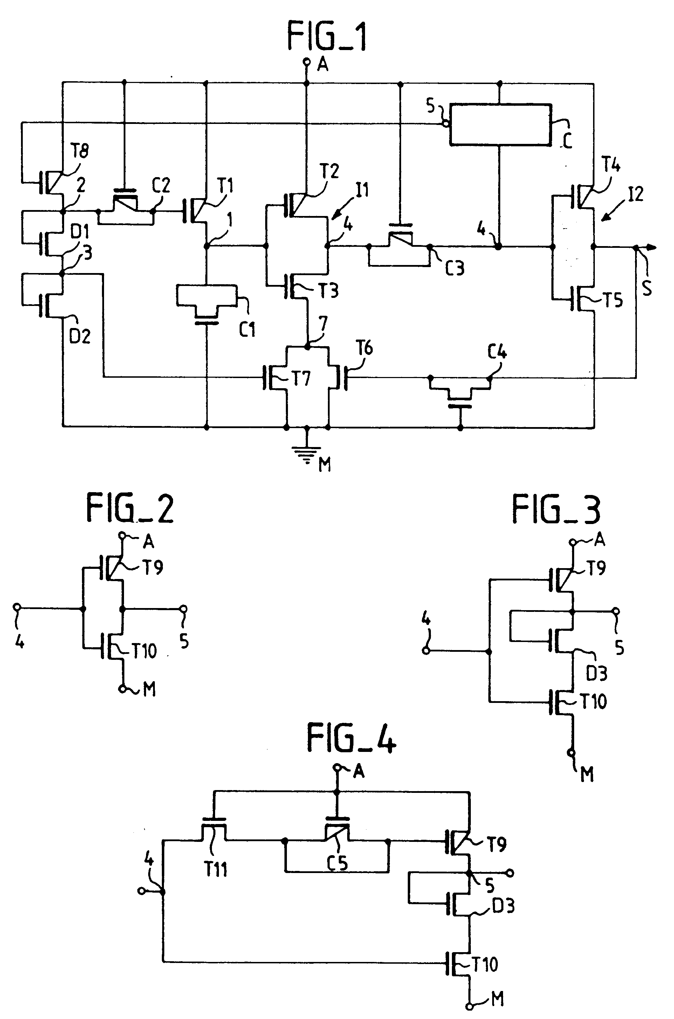

Comme représenté sur la figure 1, le circuit de remise sous tension conforme à la présente invention comporte une borne A recevant la tension d'alimentation extérieure, cette borne A étant reliée à tous les composants connectés normalement à la tension d'alimentation, une borne de masse M, cette borne recevant tous les composants connectés normalement à la masse, et une borne de sortie S autorisant ou interdisant l'alimentation du circuit intégré en fonction de la valeur de l'alimentation extérieure. D'autre part, le circuit comporte une capacité C1 constituée dans le mode de réalisation présenté par un transistor MOS de type n dont les deux électrodes principales, à savoir le drain et la source, sont court-circuitées. La grille de cette capacité C1 est reliée à la borne de masse M tandis que les deux électrodes principales court-circuitées sont reliées à un premier noeud de circuit 1. D'autre part, le premier noeud de circuit 1 est connecté à une des électrodes principales d'un premier transistor T1 de type p dont l'autre électrode principale est connectée à la borne A. La grille de ce transistor T1 est reliée à une des sorties d'un circuit diviseur par l'intermédiaire d'une capacité de stabilisation C2 comme cela sera expliqué plus loin. La capacité C1 est un élément essentiel du circuit de remise sous tension et présente la caractéristique de se charger de manière irréversible comme cela sera expliqué plus en détail ci-après.

D'autre part, le premier noeud de circuit 1 est connecté en entrée d'une porte inverseuse à tension de seuil modifiable. Cette porte inverseuse est constituée essentiellement d'un inverseur I1 proprement dit, et d'un transistor T7. De manière plus spécifique, cette porte inverseuse comporte un transistor T2 de type p dont une des électrodes principales est reliée à la borne A, son autre électrode principale est connectée à une des électrodes principales d'un transistor T3 de type n dont l'autre électrode principale est connectée en série à une des électrodes principales du transistor T7 de type p dont l'autre électrode principale est connectée à la borne M. Les grilles des transistors T2 et T3 sont reliés ensemble et connectées au premier noeud de circuit 1 tandis que la sortie de la porte inverseuse est réalisée au niveau de la connexion des transistors T2 et T3 formant un noeud de circuit 4. D'autre part, la grille du transistor T7 est reliée à une sortie du circuit diviseur formant le noeud de circuit 3.

Le circuit de la présente invention comporte d'autre part, un inverseur I2 connecté par l'intermédiaire d'une capacité de stabilisation C3 au noeud 4 constituant la sortie de la porte inverseuse. Cet inverseur 12 est constitué de manière conventionnelle par un transistor T4 de type p monté en série avec un transistor T5 de type n entre la borne A et la borne M. Les grilles des transistors T4 et T5 sont réliées ensemble et connectées au noeud 4. D'autre part, la sortie de la porte inverseuse I2 constitue la sortie S du circuit de remise sous tension. Pour réaliser le verrouillage du circuit de remise sous tension une fois délivrée l'impulsion autorisant l'alimentation du circuit intégré, la sortie S est connectée par l'intermédiaire d'une capacité de stabilisation C4 sur la grille d'un transistor T6 de type n. Le transistor T6 est monté en parallèle sur le transistor T7. D'autre part, le noeud de circuit 4 est connecté en entrée d'un circuit C présentant une fonction de transfert $V_S = f(V_E)$ de type inverseur. Ce circuit C reçoit la tension d'alimentation et envoie un signal de sortie sur une source de courant de manière à commander le fonctionnement de cette source de courant. Comme représenté sur la figure 1, la source de courant est constituée par un transistor T8 de type p dont une des électrodes principales est reliée à la borne A et dont l'autre électrode principale est relié à un circuit diviseur. La grille du transistor T8 est donc reliée au noeud 5 formant la sortie du circuit C. Le circuit diviseur utilisé dans la présente invention est constitué par deux transistors MOS de type n D1, D2 montés en diode. De manière plus spécifique, les transistors D1 et D2 sont connectés en série l'un avec l'autre et avec le transistor T8 formant source de courant. D'autre part, la grille du transistor D1 est connecté au noeud 2 de circuit formé entre le transistor T8 et le transistor D1 et la grille du transistor D2 est connectée au noeud 3 de circuit formé entre les transistors D1 et D2. De plus, le noeud 2 est relié par l'intermédiaire d'une capacité de stabilisation C2 à la grille du premier transistor T1 tandis que le noeud 3 est relié directement à la grille du transistor T7. Dans le mode de réalisation représenté, les transistors D1 et D2 ont été choisis avec des tensions de seuil différentes en leur donnant des dimensions différentes, de sorte que les tensions de seuil des diodes D1 et D2 soient différentes. D'autre part, comme représenté sur la figure 1, les différentes capacités de stabilisation C2, C3 et C4 sont constituées par des transistors de type n ou de type p dont les électrodes principales sont court-circuitées et dont la grille est connectée soit à la borne A (pour les types p) soit à la borne M (pour les types n) en fonction de la tension de stabilisation à obtenir.

On décrira maintenant avec référence aux figures 2,3 et 4, différents modes de réalisation qui peuvent être utilisés pour le circuit C.

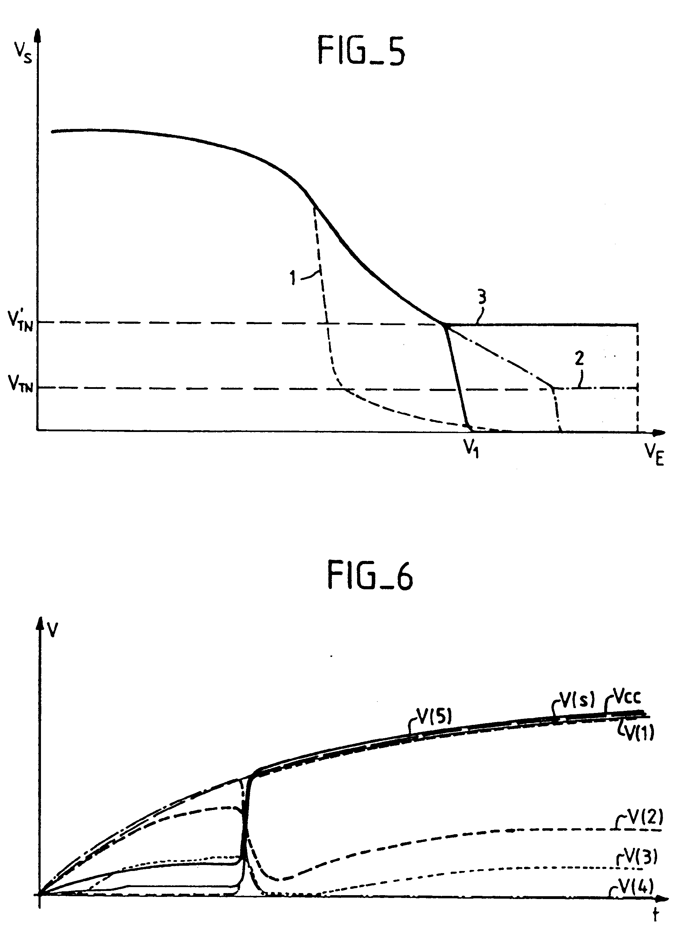

Selon un premier mode de réalisation représenté à la figure 2, le circuit C peut être constitué par un simple inverseur. Dans ce cas, il comportera, montés en série entre la borne A et la borne M, un transistor de type p T9 et un transistor de type n T10. Les grilles des deux transistors T9 et T10 sont reliées en commun et connectées au noeud d'entrée 4. Dans ce cas, la fonction de transfert $V_S = f(V_E)$ est représentée par la courbe 1 sur la figure 5. Ce système présente l'inconvénient d'avoir une constante de temps relativement importante. D'autre part, pour obtenir un fonctionnement correct, il est nécessaire de choisir les tensions de seuil des transistors T9 et T10 de manière appropriée.

Selon un autre mode de réalisation représenté sur la figure 3, on intercale entre le transistor T9 du type p et le transistor T10 de type n, un transistor D3 monté en diode. Dans ce cas, la sortie 5 de l'inverseur est réalisée au niveau de l'interconnexion entre le transistor T9 et la diode D3 formant le noeud 5. Avec ce circuit, la courbe de transfert est la courbe représentée avec des points et des tirets sur la figure 5.

Lors de la première utilisation, la tension de sortie passe de 0 à 5 Volts, mais ensuite, la tension de sortie $V_S$ ne peut pas redescendre en dessous de la tension de conduction du transistor n. Elle évolue donc entre $VT_n$ et 5 Volts.

Selon un mode de réalisation préférentiel, le circuit C est constitué par le circuit représenté à la figure 4. Dans ce cas, la grille du transistor T9 est reliée au noeud d'entrée 4 par l'intermédiaire d'une capacité de stabilisation C5 qui peut être omise et par l'intermédiaire d'un transistor T11 de type n. La capacité C5 est constituée par un transistor p dont les deux électrodes principales sont court-circuitées et dont la grille est reliée à la borne d'alimentation A. Les électrodes principales du condensateur C5 sont reliées à la grille T9 et à une des électrodes principales du transistor T11 dont la grille est aussi reliée à la borne d'alimentation A. Avec le circuit de la figure 4, on obtient la fonction de transfert $V_S = f(V_E)$ représentée par la courbe 3 sur la figure 5. Dans ce cas, la tension $V_S$ reste sensiblement égale à 0 jusqu'à ce que la tension d'entrée soit descendue jusqu'à V1. Ensuite, la tension $V_S$ grimpe très rapidement jusqu'à $V'T_n$, puis elle suit la courbe de transfert du circuit de la figure 3. Comme dans le cas du système de la figure 3, il existe une fonction anti-retour et la tension de sortie $V_S$ ne peut plus évoluer qu'entre 5 Volts et $V'T_n$. Cette tension de sortie est dans tous les cas utilisée pour commander la source de tension réalisé par le transistor T8.

Les deux derniers circuits présentent l'avantage d'avoir une pente $V_S/V_E$ relativement faible dans une certaine zone de fonctionnement, ce qui en fait un système quasi-linéaire.

On expliquera maintenant avec référence à la figure 6, le fonctionnement du circuit de la figure 1 dans le cas où le circuit C est constitué par le circuit représentée à la figure 4.

Sur la figure 6, on a donc représenté les courbes suivantes :

– Vcc représente la variation temporelle de la tension d'alimentation extérieure appliquée sur la borne A. On suppose que cette tension croît exponentiellement jusqu'à une valeur comprise entre 4,5 Volts et 5 Volts, valeur à laquelle elle se stabilise ;

– V(1), V(2), V(3), V(4), V(5) et V(S) représentent les variations de tension au niveau des différents noeuds de circuit.

La tension de seuil des transistors à canal p (en particulier T8 et T1) est désignée par $VT_p$ et la tension de seuil des transistors à canal n (en particulier T3, T10, T11, T7, T6) est désignée par $VT_n$.

1°. A la mise sous tension, le noeud 1 est à zéro, car la capacité C1 est reliée à la masse ; le second 4 est à Vcc du fait de la capacité C3 reliée à Vcc ; la sortie S est à zéro ; la tension sur la grille T9 est à Vcc à cause de la capacité C5 ; le transistor T8 ne conduit pas encore ;

2°. lorsque Vcc atteint $VT_p$ le transistor T8 se met à conduire, on injecte du courant dans les transistors montés en diode D1 et D2. La tension au point 2 augmente alors en suivant Vcc et la tension au point 3 se met à croître dès que la tension de seuil du transistor D1 monté en diode est atteinte. La tension au point 3 suit la tension au point 2, selon le rapport de division donné par la tension de seuil de deux transistors montés en diode. Dès que la tension au point 2 est telle que $Vcc=VT_p+VT_{D1}+VT_{D2}$, T1 se met aussi à conduire et la capacité C1 se charge très lentement.

3°. lorsque $Vcc \geqq VT_p + VT_{D1} + VT_{D2}$, $VT_{D1}$ et $VT_{D2}$ étant les tensions de seuil des diodes, la tension au point 4 chute brutalement, comme représenté sur la figure 6, la tension au point 5 peut croître, ce qui bloque le transistor T8. On n'injecte donc plus de courant dans les diodes D1 et D2. La tension aux points 2 et 3 chute donc. Comme la tension au point 4 diminue, la tension au point 5 en sortie de l'inverseur I2 augmente et se met à suivre la tension Vcc. D'autre part, le transistor T7 se bloque mais le transistor T6 devient passant. La capacité C1 continue à se charger en suivant Vcc. En conséquence, le point 4 est maintenu à zéro.

La commutation est donc obtenue pour $Vcc = VT_p + VT_{D1} + VT_{D2}$ qui, dans le mode de réalisation représenté à la figure 6, est choisie égale à 3 Volts.

Avec ce système, il est donc possible d'obtenir une commutation pour une tension Vcc comprise entre 3 Volts et 4,5 Volts. D'autre part, comme représenté sur la figure 6, cette commutation est très rapide.

Il est évident pour l'homme de l'art que le circuit de la présente invention peut être modifié notamment par l'emploi d'équivalents.

## Revendications

1. Circuit de remise sous tension pour assurer le démarrage d'un circuit intégré en technologie MOS, comprenant :
   – une borne (A) recevant la tension d'alimentation, une borne de masse (M) et une borne de sortie (S) délivrant une impulsion de démarrage,
   – une capacité (C1) connectée entre la borne de masse et un premier noeud de circuit (1), capacité dont la charge est commandée par un premier transistor (T1) de type P,
   – une porte inverseuse (I1, T7) dont l'entrée est connectée au premier noeud de circuit,
   – une source de courant (T8) commandant le premier transistor de type P,
   – un circuit (C) présentant une fonction de transfert de type inverseur, ledit circuit étant connecté à la source de courant de manière à commander le fonctionnement de celle-ci,

le circuit de remise sous tension étant caractérisé en ce que :
   – le premier transistor (T1) de type p est connecté entre la borne A et le premier noeud (1),
   – la porte inverseuse (I1, T7) a un seuil modifiable,
   – un inverseur (I2) est connecté entre la sortie de la porte inverseuse et la borne de sortie,
   – un circuit diviseur (D1, D2), destiné à la commande de seuil de la porte inverseuse (I1, T7), est connecté en série avec la source de courant (T8),
   – et l'entrée du circuit à fonction de transfert du type inverseur est connectée à la sortie de la porte inverseuse.

2. Circuit selon la revendication 1, caractérisé en ce que la porte inverseuse à tension de seuil modifiable est constitué par un inverseur (I1) relié à la borne M par l'intermédiaire d'un deuxième transistor (T7) dont la grille est connectée en sortie (3) du circuit diviseur.

3. Circuit selon l'une quelconque des revendications 1 et 2, caractérisé en ce qu'il comporte de plus un troisième transistor (T6) monté en parallèle sur le deuxième transistor (T7), la grille du troisième transistor étant reliée à la borne de sortie S.

4. Circuit selon l'une quelconque des revendications 1 à 3, caractérisé en ce que le circuit diviseur est constitué par deux transistors MOS (D1, D2) montés en diode.

5. Circuit selon l'une quelconque des revendications 1 à 4, caractérisé en ce que la source de courant est constitué par un quatrième transistor (T8) de type p.

6. Circuit selon l'une quelconque des revendications 1 à 5, caractérisé en ce que le circuit (C) présentant une fonction de transfert de type inverseur est constitué par un simple inverseur (T9, T10).

7. Circuit selon l'une quelconque des revendications 1 à 5, caractérisé en ce que le circuit (C) présentant une fonction de transfert de type inverseur est constitué par un inverseur (T9, T10) comportant entre un cinquième transistor (T9) de type p et un transistor (T8) de type n un transistor (D3) monté en diode, la sortie (5) de l'inverseur étant prélevée au noeud formé entre le transistor (T9) de type p et le transistor (D3) monté en diode.

8. Circuit selon l'une quelconque des revendications 1 à 5, caractérisé en ce que le circuit (C) présentant une fonction de transfert de type inverseur est constitué par le montage en série entre la borne A et la borne M d'un cinquième transistor (T9) de type p, d'un transistor (D3) monté en diode et d'un sixième transistor (T8) de type n, la borne d'entrée (5) du circuit étant connectée, par l'intermédiaire d'un septième transistor (T11) de type n dont la grille est reliée à la borne A, à la grille du cinquième transistor (T9) de type p et directement à la grille du sixième transistor (T10) de type n et la borne de sortie (5) du circuit étant réalisée au niveau du noeud de circuit formé entre le cinquième transistor (T9) de type p et le transistor (D3) monté en diode.

9. Circuit selon la revendication 8, caractérisé en ce qu'il comporte de plus une capacité (C5) montée en série entre le septième transistor (T11) et la grille du cinquième transistor (T9).

10. Circuit selon l'une quelconque des revendications 1 à 9, caractérisé en ce qu'il comporte en outre une capacité (C2) entre une sortie (2) du circuit diviseur et le premier noeud (1) de circuit, une capacité (C3) entre la sortie (4) de la porte inverseuse et l'entrée (E) du circuit (C) présentant une fonction de transfert de type inverseur et une capacité (C4) entre la borne de sortie (S) et la grille du troisième transistor (T6).

11. Circuit selon la revendication 10, caractérisé en ce que les capacités (C2, C3, C4) sont constituées par des transistors MOS de type p ou de type n dont les deux électrodes principales sont court-circuitées et dont la grille est reliée soit à la borne A pour les transistors de type p, soit à la borne M pour les transistors de type n.

## Patentansprüche

1. Spannungs-Wiederanlegeschaltung zum Sicherstellen des Einschaltens einer integrierten Schaltung in MOS- Technologie, mit:
- einem Anschluß (A) für die Versorgungsspannung, einem Masseanschluß (M) und einem Ausgangsanschluß (S), der einen Einschaltimpuls liefert,
- einer Kapazität (C1), die zwischen den Masseanschluß und einen ersten Schaltungsknoten (1) geschaltet ist und deren Ladung von einem ersten P-Kanal-Transistor (T1) gesteuert wird,
- einer Inverter-Torschaltung (I1, T7), deren Eingang mit dem ersten Schaltungsknoten verbunden ist,
- einer Stromquelle (T8), die den ersten P-Kanal-Transistor steuert,
- einer Schaltung (C), die eine Invertierungs-Übertragungsfunktion aufweist und mit der Stromquelle so verbunden ist, daß sie die Funktion derselben steuert,
wobei die Spannungs-Wiederanlegeschaltung dadurch gekennzeichnet ist, daß:
- der erste P-Kanal-Transistor (T1) zwischen den Anschluß (A) und den ersten Knoten (1) geschaltet ist,
- die Inverter-Torschaltung (I1, T7) eine veränderbare Schwelle besitzt,

- zwischen den Ausgang der Inverter-Torschaltung und den Ausgangsanschluß ein Invertierer (I2) geschaltet ist,
- eine Teilerschaltung (D1, D2), die zur Steuerung der Schwelle der Inverter-Torschaltung (I1, T7) vorgesehen ist, mit der Stromquelle (T8) in Reihe geschaltet ist,
- und der Eingang der Schaltung mit Invertierungs-Übertragungsfunktion mit dem Ausgang der Inverter-Torschaltung verbunden ist.

2. Schaltung gemäß Anspruch 1, dadurch gekennzeichnet, daß die Inverter-Torschaltung mit veränderbarer Schwellenspannung von einem Invertierer (I1) gebildet wird, der über einen zweiten Transistor (T7), dessen Gate mit dem Ausgang (3) der Teilerschaltung verbunden ist, mit dem Anschluß M verbunden ist.

3. Schaltung gemäß einem der Ansprüche 1 und 2, dadurch gekennzeichnet, daß sie außerdem einen dritten Transistor (T6) aufweist, der parallel zum zweiten Transistor (T7) angeordnet ist, wobei das Gate des dritten Transistors mit dem Ausgangsanschluß S verbunden ist.

4. Schaltung gemäß einem der Ansprüche 1 bis 3, dadurch gekennzeichnet, daß die Teilerschaltung von zwei als Diode angeordneten MOS-Transistoren (D1, D2) gebildet wird.

5. Schaltung gemäß einem der Ansprüche 1 bis 4, dadurch gekennzeichnet, daß die Stromquelle von einem vierten P-Kanal-Transistor (T8) gebildet wird.

6. Schaltung gemäß einem der Ansprüche 1 bis 5, dadurch gekennzeichnet, daß die eine Invertierungs-Übertragungsfunktion aufweisende Schaltung (C) von einem einfachen Invertierer (T9, T10) gebildet wird.

7. Schaltung gemäß einem der Ansprüche 1 bis 5, dadurch gekennzeichnet, daß die eine Invertierungs-Übertragungsfunktion aufweisende Schaltung (C) von einem Invertierer (T9, T10) gebildet wird, der zwischen einem fünften P-Kanal-Transistor (T9) und einem N-Kanal-Transistor (T8) einen als Diode angeordneten Transistor (D3) aufweist, wobei die Ausgabe (5) des Invertierers an dem Knoten, der zwischen dem P-Kanal-Transistor (T9) und dem als Diode angeordneten Transistor (D3) gebildet ist, abgegriffen wird.

8. Schaltung gemäß einem der Ansprüche 1 bis 5, dadurch gekennzeichnet, daß die eine Invertierungs-Übertragungsfunktion aufweisende Schaltung (C) durch die Reihenschaltung eines als Diode angeordneten Transistors (D3) und eines sechsten N-Kanal-Tansistors (T8) zwischen dem Anschluß A und dem Anschluß M eines fünften P-Kanal-Transistors (T9) gebildet wird, wobei der Eingangsanschluß (5) der Schaltung über einen siebten N-Kanal-Transistor (T11), dessen Gate mit dem Anschluß A verbunden ist, mit dem Gate des fünften P-Kanal-Transistors (T9) und direkt mit dem Gate des sechsten N-Kanal-Transistors (T10) verbunden ist und wobei der Ausgangsanschluß (5) der Schaltung auf Höhe des Schaltungsknotens, der zwischen dem fünften P-Kanal-Transistor (T)) und dem als Diode angeordneten Transistor (D3) gebildet wird, verwirklicht wird.

9. Schaltung gemäß Anspruch 8, dadurch gekennzeichnet, daß sie außerdem eine zwischen dem siebten Transistor (T11) und dem Gate des fünften Transistors (T9) in Reihe geschaltete Kapazität (C5) aufweist.

10. Schaltung gemäß einem der Ansprüche 1 bis 9, dadurch gekennzeichnet, daß sie außerdem eine zwischen einen Ausgang (2) der Teilerschaltung und den ersten Schaltungsknoten (1) geschaltete Kapazität (C2), eine zwischen den Ausgang (4) des NICHT-Gatters und den Eingang (E) der eine Invertierungs-Übertragungsfunktion aufweisenden Schaltung (C) geschaltete Kapazität (C3) und eine zwischen den Ausgangsanschluß (S) und das Gate des dritten Transistors (T6) geschaltete Kapazität (C4) umfaßt.

11. Schaltung gemäß Anspruch 10, dadurch gekennzeichnet, daß die Kapazitäten (C2, C3, C4) von P-Kanal- oder N-Kanal-MOS-Transistoren gebildet werden, deren zwei Hauptelektroden kurzgeschlossen sind und deren Gate entweder für die P-Kanal-Transistoren mit dem Anschluß A oder für die N-Kanal-Transistoren mit dem Anschluß M verbunden ist.

## Claims

1. A power-on reset circuit for starting an integrated MOS circuit, comprising:
   – a terminal (A) receiving the supply voltage, a ground terminal (M) and an output terminal (S) supplying a starting pulse,
   – a capacitor (C1) connected between the ground terminal and a first circuit junction (1), said capacitor having its charge controlled by a first type P transistor (T1),
   – an inverting gate (I1 and T7) whose input is connected with the first circuit junction,
   – a source of current (T8) controlling the first type P transistor,
   – a circuit (C) presenting a transfer function of the inverting type, said circuit being connected with the source of power in such a manner as to control the operation of the same,
   said power-on reset circuit being characterized in that:
   – the first type p transistor (T1) is connected between the terminal A and the first junction (1),
   – the inverting gate (I1 and T7) has a modifiable threshold,
   – one inverter (I2) is connected between the output of the inverting gate and the output terminal,
   – a dividing circuit (D1 and D2), adapted for the control of the threshold of the inverting gate (I1 and T7), is connected in series with the source (18) of current.
   – and the input of the circuit with a transfer function of the inverting type is connected at the output of the inverting gate.

2. The circuit as claimed in claim 1, characterized in that the inverting gate with a modifiable threshold voltage is constituted by an inverter (I1) connected with the terminal M by means of a second transistor (T7) whose gate is connected as the output (3) of the dividing circuit.

3. The circuit as claimed in claim 1 or in claim 2, characterized in that it comprises furthermore a third transistor (T6) placed in parallel with the second transistor (T7), the gate of the third transistor being connected with the output terminal S.

4. The circuit as claimed in any one of the preceding claims 1 through 3, characterized in that the dividing circuit is constituted by two MOS transistors (D1 and D2) placed in circuit as diode.

5. The circuit as claimed in any one of the preceding claims 1 through 4, characterized in that the source of current is constituted by a fourth type p transistor (T8).

6. The circuit as claimed in any one of the preceding claims 1 through 5, characterized in that the circuit (C) having an inverter type transfer function is constituted by a simple inverter (T9 and T10).

7. The circuit as claimed in any one of the preceding claims 1 through 5, characterized in that the circuit (C) having an inverter type transfer function is constituted by an inverter (T9 and T10) comprising, between a fifth type p transistor (T9) and a type n transistor (T8), a transistor (D3) placed in circuit as a diode, the output (5) of the inverter being taken at the junction between the type p transistor (T9) and the transistor (D3) placed to act as a diode.

8. The circuit as claimed in any one of the preceding claims 1 through 5, characterized in that the circuit (C) having an inverter type transfer function is constituted by the placement in series, between the terminal A and the terminal M of the a fifth type p transistor (T9), of a transistor (D3) placed in circuit as a diode and of a sixth type n transistor (T8), the input terminal (5) of the circuit being connected, by means of a seventh type n transistor (T11), whose gate is connected with the terminal A, with the gate of the fifth type p transistor (T9) and directly with the gate of the sixth type n transistor (T10) and the output terminal (5) of the circuit being formed at the same level as the circuit junction formed between the fifth type p transistor (T9) and the transistor (D3) placed in circuit as a diode.

9. The circuit as claimed in claim 9, characterized in that it furthermore comprises a capacitor (C5) placed in series between the seven transistor (T11) and the gate of the fifth transistor (T9).

10. The circuit as claimed in any one of the preceding claims 1 through 9, characterized in that it furthermore comprises a capacitor (C2) placed between an output (2) of the dividing circuit and the first circuit junction (1), a capacitor (C3) between the output (4) of the inverting gate and the input (E) of the circuit (C) having an inverting type transfer function and a capacitor (C4) between the output terminal (S) and the gate of the third transistor (T6).

11. The circuit as claimed in claim 10, characterized in that the capacitors (C2, C3 and C4) are constituted by type p or type n MOS transistors whose two main electrodes are short-circuited and whose gate is connected either with the terminal A for the type p transistors or with the M terminal for the type n transistors.

# FIG_1

# FIG_2

# FIG_3

# FIG_4

FIG_5

FIG_6